# EUROPÄISCHE PATENTSCHRIFT

(11) **EP 2 845 233 B1**
(45) Veröffentlichungstag und Bekanntmachung des Hinweises auf die Patenterteilung: **09.05.2018**
(21) Anmeldenummer: 13707886.1
(22) Anmeldetag: 07.03.2013
(51) Int. Cl.: H01L 33/58, F21V 9/16

(54) **LED-MODUL**
LED MODULE
MODULE DE DEL

(30) Priorität: 30.04.2012 DE 102012207169; 04.06.2012 DE 102012209354
(43) Veröffentlichungstag der Anmeldung: 11.03.2015
(73) Patentinhaber: Tridonic Jennersdorf GmbH, 8380 Jennersdorf (AT); AT & S Austria Technologie & Systemtechnik Aktiengesellschaft, 8700 Leoben-Hinterberg (AT)
(72) Erfinder: HOSCHOPF, Hans, A-8380 Jennersdorf (AT); LUTSCHOUNIG, Ferdinand, A-9170 Ferlach (AT); VOLKHEIMER, Eva Maria, A-8380 Jennersdorf (AT); WENZL, Franz-Peter, A-8565 St. Johann ob Hohenburg (AT)
(74) Vertreter: Rupp, Christian
(86) Internationale Anmeldenummer: PCT/EP2013/054622
(87) Internationale Veröffentlichungsnummer: WO 2013/164114

(56) Entgegenhaltungen:
- EP-A1- 2 261 551
- US-A1- 2008 308 825
- US-A1- 2009 003 002
- US-A1- 2011 266 574

## Beschreibung

Die vorliegende Erfindung betrifft ein LED-Modul mit einem Träger, einem darauf aufgebrachten LED-Chip sowie einem optischen Element, welches einen oberhalb des LED-Chips vorgesehenen lichtdurchlässigen Raum umgibt, und einen Träger (z.B. eine Leiterplatte) mit optischem Element.

Derartige LED-Module sind aus dem Stand der Technik bekannt. In der Regel liegen mehrere LED-Chips auf dem Träger vor, und das optische Element weist entsprechend der Anzahl und Anordnung der LED-Chips vorgenannte Räume auf, so dass durch Aufsetzen und Befestigen des optischen Elements auf dem Träger das optische Element bzw. deren Räume definiert bezüglich der LED-Chips ausgerichtet sind. Da die Abstrahlung der LED-Chips in Hauptabstrahlrichtung desselben besonders intensiv ist, weisen die bekannten LED-Module eine inhomogene Lichtverteilung auf.

Es ist somit eine Aufgabe der Erfindung, vorgenannte LED-Module und Träger derart auszubilden, dass diese eine homogene Lichtverteilung aufweisen bzw. ermöglichen. Die Offenbarung US 2011/0266574 A1 offenbart ein LED-Modul mit einer halbrunden Verkapselungsschicht über ein LED-Chip, wobei die Verkapselungsschicht Streupartikel aufweist deren Konzentration in einem Bereich, der mit der Oberfläche des LED-Chips in einer vorzugsweise dazu senkrechten Hauptabstrahlrichtung gesehen fluchtet, höher ist als in einem Bereich, welcher nicht mit der Oberfläche des LED-Chips in Hauptabstrahlrichtung gesehen fluchtet. Es wird auf dieser Weise eine homogene Lichtabstrahlung erzielt. Die Offenbarung US 2009/0003002 A1 offenbart ein LED-Modul mit über ein LED-Chip positionierten reflektierenden Elementen die aufgrund deren Verteilung eine homogene Lichtabstrahlung erzielen. Die vorgenannte Aufgabe der Erfindung wird auf einer verbesserten Weise durch den Gegenstand der jeweiligen unabhängigen Ansprüche gelöst. Die abhängigen Ansprüche bilden den zentralen Gedanken der Erfindung in besonders vorteilhafter Weise weiter. Gemäß einem ersten Aspekt der Erfindung wird ein LED-Modul vorgeschlagen, welches einen Träger, insbesondere eine Leiterplatte, aufweist, auf dem bzw. in dem wenigstens ein LED-Chip aufgebracht bzw. eingesetzt ist. Ferner weist das LED-Modul ein optisches Element, vorzugsweise eine optische Platte, auf, welche(s) einen oberhalb des LED-Chips vorgesehenen, lichtdurchlässigen Raum begrenzt, vorzugsweise diesen umgibt. In dem optischen Element sind Streupartikel vorgesehen. Die Konzentration der Streupartikel ist in einem Bereich, der mit der Oberfläche des LED-Chips in einer vorzugsweise dazu senkrechten Hauptabstrahlrichtung gesehen fluchtet, höher als in einem Bereich, welcher nicht mit der Oberfläche des LED-Chips in Hauptabstrahlrichtung gesehen fluchtet, wobei die den Raum bildenden Begrenzungswände eine Strukturierung zur verbesserten Einkopplung des von dem LED-Chip emittierten Lichts in das optische Element in Form einer Fresnel-Linse aufweisen. Durch die erfindungsgemäße gezielte Konzentration der Streupartikel in dem optischen Element, insbesondere in einem Bereich der Hauptabstrahlrichtung des LED-Chips, kann eine besonders homogene Lichtverteilung und somit Lichtabstrahlung des LED-Moduls erreicht werden. Hierzu wird insbesondere das in Hauptabstrahlrichtung intensiv emittierte Licht besonders stark gestreut, so dass in dem optischen Element eine homogene Durchmischung des Lichts stattfindet, was schließlich, in Kombination mit der Wirkung der Fresnel-Linse zu der homogenen Lichtabstrahlung des LED-Moduls führt.

Gemäß einem zweiten Aspekt der Erfindung wird ein LED-Modul vorgeschlagen, welches einen Träger, insbesondere eine Leiterplatte, aufweist, auf dem bzw. in dem wenigstens ein LED-Chip aufgebracht bzw. eingesetzt ist. Ferner weist das LED-Modul ein optisches Element, vorzugsweise eine optische Platte, auf, welche(s) einen oberhalb des LED-Chips vorgesehenen, lichtdurchlässigen Raum begrenzt, vorzugsweise diesen umgibt. Auf einer von dem LED-Chip abgewandten Seite des optischen Elements und wenigstens in einem zur Oberfläche des LED-Chips in einer vorzugsweise dazu senkrechten Hauptabstrahlrichtung gesehen fluchtenden Oberflächenbereich ist wenigstens ein reflektierendes Element vorgesehen, so dass die Abstrahlung des LED-Chips in Hauptabstrahlrichtung vorzugsweise über das gesamte optische Element gleichmäßig verteilt wird, wobei die den Raum bildenden Begrenzungswände eine Strukturierung zur verbesserten Einkopplung des von dem LED-Chip emittierten Lichts in das optische Element in Form einer Fresnel-Linse aufweisen. Durch das Vorsehen erfindungsgemäßer reflektierender Elemente auf dem optischen Element, insbesondere in einem Bereich der Hauptabstrahlrichtung des LED-Chips, kann, in Kombination mit der Wirkung der Fresnel-Linse eine besonders homogene Lichtverteilung und somit Lichtabstrahlung des LED-Moduls erreicht werden. Hierzu reflektieren die reflektierenden Elemente insbesondere das in Hauptabstrahlrichtung intensiv emittierte Licht zurück in das optische Element bzw. in Richtung des Trägers, wo es homogen durchmischt und schließlich homogen abgestrahlt wird.

Die Erfindung ist nicht nur auf vorgenannte LED-Module gerichtet, sondern umfasst auch den Träger mit dem optischen Element selbst; also ohne LED-Chip.

So wird gemäß einem dritten Aspekt ferner ein Träger, insbesondere eine Leiterplatte, vorgeschlagen, welcher ein optisches Element aufweist, vorzugsweise eine optische Platte, welches einen oberhalb des Trägers, insbesondere oberhalb eines Bereichs des Trägers zum Anbringen oder Einsetzen eines LED-Chips auf bzw. in den Träger vorgesehenen, lichtdurchlässigen Raum begrenzt, vorzugsweise umgibt, und welcher Streupartikel aufweist. In diesem Fall ist die Konzentration der Streupartikel in einem Bereich oberhalb des Raumes bezüglich des Trägers, insbesondere in einem Bereich, der mit einer Oberfläche eines vorzusehenden LED-Chips in einer vorzugsweise dazu senkrechten Hauptabstrahlrichtung gesehen fluchtet, höher als in einem Bereich, welcher nicht oberhalb des Raumes bezüglich des Trägers angeordnet ist, insbesondere welcher nicht mit der Oberfläche des vorzusehenden LED-Chips in Hauptabstrahlrichtung gesehen fluchtet, um eine homogene Lichtabstrahlung zu erzielen.

Gemäß einem vierten Aspekt wird ein Träger vorgeschlagen, insbesondere eine Leiterplatte, welcher ein optisches Element aufweist, vorzugsweise eine optische Platte, welches einen oberhalb des Trägers, insbesondre oberhalb eines Bereichs des Trägers zum Anbringen oder Einsetzen eines LED-Chips auf bzw. in den Träger vorgesehenen, lichtdurchlässigen Raum begrenzt, vorzugsweise umgibt. Auf einer von dem Träger, insbesondere einer einen LED-Chip aufnehmenden Oberfläche des Trägers, abgewandten Seite des optischen Elements und wenigstens in einem oberhalb des Raumes bezüglich des Trägers angeordneten, insbesondere in einem zu einer Oberfläche eines vorzusehenden LED-Chips in einer vorzugsweise dazu senkrechten Hauptabstrahlrichtung gesehen fluchtenden Oberflächenbereich, ist wenigstens ein reflektierendes Element derart vorgesehen, dass eine Abstrahlung eines vorzusehenden LED-Chips in Hauptabstrahlrichtung vorzugsweise über das gesamte optische Element gleichmäßig verteilt wird, um eine homogene Lichtabstrahlung zu erzielen.

Weitere Ausgestaltungen, Weiterbildungen und Vorteile der Erfindung werden im Folgenden anhand von Ausführungsbeispielen der Figuren der begleitenden Zeichnung erläutert.
- Figur 1: zeigt ein erstes Ausführungsbeispiel eines LED-Moduls gemäß Aspekte der Erfindung,
- Figur 2: zeigt ein zweites Ausführungsbeispiel eines LED-Moduls gemäß Aspekte der Erfindung,
- Figur 3: zeigt ein drittes Ausführungsbeispiel eines LED-Moduls gemäß Aspekte der Erfindung,
- Figur 4: zeigt ein viertes Ausführungsbeispiel eines LED-Moduls gemäß Aspekte der Erfindung,
- Figur 5: zeigt ein fünftes Ausführungsbeispiel eines LED-Moduls gemäß Aspekte der Erfindung, und
- Figur 6: zeigt ein sechstes Ausführungsbeispiel eines LED-Moduls gemäß Aspekte der Erfindung.

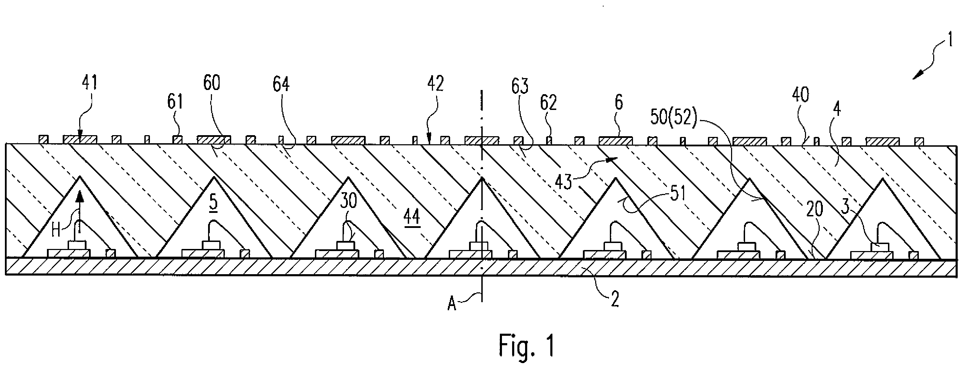

Die Figuren 1 bis 6 zeigen jeweils ein Ausführungsbeispiel eines LED-Moduls 1 gemäß Aspekte der Erfindung. Das LED-Modul 1 weist ein erfindungsgemäßes Basissubstrat bzw. einen Träger 2 auf. Der Träger 2 ist Teil des LED-Moduls 1. Der Träger 2 ist insbesondere eine Leiterplatte, vorzugsweise eine Leiterplatte aus Epoxidharz (z.B. FR4 oder CEM3), eine keramische Leiterplatte oder eine Aluminiumkern-Leiterplatte (Insulated Metal Substrate; IMS).

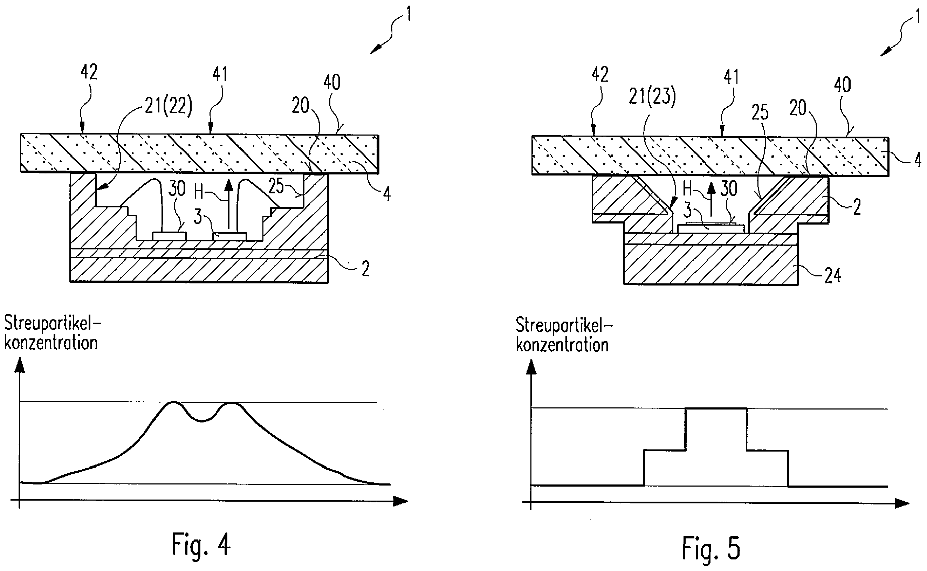

Auf dem Träger 2 ist gemäß den ersten beiden Aspekten der Erfindung wenigstens eine LED bzw. ein LED-Chip 3 aufgebracht. Es ist im Sinne eines "LED-in-Cavity"-Aufbaus (vgl. Figur 4) oder eines "Board-in-Board"-Aufbaus (vgl. Figur 5) denkbar, dass der LED-Chip 3 in den Träger 2 eingesetzt ist; bspw. in eine in den Figuren 4 und 5 dargestellte Ausnehmung 21 in dem Träger 2. Die LED-Chips 3 können monochromatische gleichfarbige oder verschiedenfarbige LED-Chips 3 sein und Licht derselben oder unterschiedlicher Wellenlängen emittieren. Die LED-Chips 3 können mit einem bspw. durch ein Dispensverfahren aufgebrachten Globe-Top oder einer anderen Abdeckung abgedeckt sein. Insbesondere können die LED-Chips 3 wenigstens eine blaue oder UV-LED aufweisen, deren Licht durch Farbkonversionspartikel teilweise in Licht mit anderer Wellenlänge umgesetzt wird, wobei das Mischlicht vorzugsweise im weißen Spektrum liegt. Es ist bspw. auch eine RGB-LED-Chip-Anordnung denkbar.

Weist das LED-Modul 1 mehrere LEDs 3 auf, so können diese in Reihe, in einer Matrixanordnung oder in sonstiger Weise strukturiert oder unstrukturiert verteilt auf dem Träger 2 vorgesehen sein. Der LED-Chip 3 kann mittels Nacktchipmontage (d.h. Chip-On-Board (COB) Technologie) oder Oberflächenmontage (d.h. Surface Mounted Technology; SMT) auf dem Träger 2 befestigt sein. Beispielsweise kann der LED-Chip 3 in herkömmlicher Weise unter elektrischer Kontaktierung durch Bonden (vgl. Figuren 1 bis 4) oder mittels Flip-Chip Technik (vgl. Figur 5) auf dem Träger 2 aufgebracht bzw. in diesem eingesetzt sein. In einer bevorzugten Ausführungsform werden auf veredelte, also bspw. goldbeschichtete oder silberbeschichtete Kupferoberflächen (Leiterbahnbild) des Trägers 2 die LED-Chips 3 aufgesetzt.

Wenigstens die Oberfläche 20 (vgl. insbesondere Figuren 1 bis 3) des Trägers 2, auf der die LED-Chips 3 vorgesehen bzw. vorzusehen sind, also die Oberseite des Trägers 2, kann reflektierend, vorzugsweise hochreflektierend sein. Hierzu kann der Träger 2 aus einem reflektierenden Material, bspw. Aluminium oder Kupfer, hergestellt sein. Es ist alternativ oder zusätzlich auch denkbar, dass die Reflexionseigenschaft durch eine entsprechende Bearbeitung der Trägeroberfläche 20 oder eine Beschichtung des Trägers 2 hervorgerufen oder verbessert wird. Als Beschichtungsmaterialien kommen beispielsweise keramische Tinte, weißer Lötstopplack oder Silber in Betracht. Auch Titandioxid bspw. als Pigment in einer Beschichtung ist denkbar.

Das LED-Modul 1 bzw. der Träger 2 weisen ferner ein optisches Element 4 auf, welches einen oberhalb des LED-Chips 3 vorgesehenen, lichtdurchlässigen Raum 5 begrenzt, vorzugsweise diesen umgibt. Das optische Element 4 kann den Raum 5 folglich lediglich in einem oberen Bereich desselben begrenzen; also bspw. den Raum 5 oben abdecken oder in einem oberen Bereich umgeben. Begrenzt das optische Element 4 den Raum 5 über seine gesamte Höhe, so umgibt das optische Element 4 den gesamten Raum 5. Mit anderen Worten weist das LED-Modul 1 das optische Element 4 auf, welches den oberhalb des LED-Chips 3 vorgesehenen, lichtdurchlässigen Raum 5 wenigstens teilweise begrenzt bzw. umgibt. Weist das LED-Modul 1 wenigstens zwei oder mehr LED-Chips 3 auf (Figuren 1 bis 3: je sieben LED-Chips 3; Figur 4: zwei LED-Chips 3), ist jeweils einem LED-Chip 3 (wie in den Figuren 1 bis 3 gezeigt) oder mehreren LED-Chips 3 (wie in der Figur 4 gezeigt) ein Raum 5 bspw. in dem optischen Element 4 oder wenigstens durch dieses wenigstens teilweise begrenzt zugeordnet, und der Raum 5 umgibt die LED-Chips 3 folglich. Ist gemäß dem dritten und vierten Aspekt diese lediglich auf den Träger 2 mit optischem Element 4 gerichtet, also ohne LED-Chip 3, so begrenzt (vorzugsweise umgibt) das optische Element 4 den oberhalb des Trägers 2, insbesondere oberhalb eines Bereichs des Trägers 2 zum Anbringen oder Einsetzen des LED-Chips 3 auf bzw. in den Träger 2, vorgesehenen, lichtdurchlässigen Raum 5.

Das optische Element 4 ist vorzugsweise aus einem hochtransparenten Material hergestellt, wie beispielsweise aus einem (vorzugsweise formbaren) Matrixmaterial, z.B. Epoxidharz, aus Kunststoff oder aus Glas. In einer besonders bevorzugten Ausführungsform ist das optische Element 4 als Platte, also als optische Platte ausgebildet.

Das optische Element 4 ist vorzugsweise auf dem Träger 2, genauer auf der den LED-Chip 3 aufweisenden Seite des Trägers 2 bzw. in Abstrahlrichtung des (vorzusehenden) LED-Chips 3 vor diesem auf dem Träger 2 vorgesehen und befestigt. Das optische Element 4 kann hierzu durch Kleben, Schrauben oder äußere Verklebung definiert auf dem Träger 2 befestigt sein. Unter "definiert" wird im Rahmen der Erfindung verstanden, dass das optische Element 4 derart auf dem Träger 2 vorgesehen ist, dass nach dem Aufsetzen des optischen Elements 4 der oder die LED-Chips 3 genau in den dafür vorgesehenen abgegrenzten Räumen 5 platziert sind. Insbesondere in einem Fall, in dem das optische Element 4 den Raum 5 wenigstens teilweise umgibt, kann somit sichergestellt werden, dass ein berechneter Kurvenverlauf und Abstand von Begrenzungswänden 50 des Raumes 5 (wie im Weiteren noch näher erläutert wird) über dem LED-Chip 3 stets eingehalten ist. Das optische Element 4 liegt vorzugsweise vollflächig (ausgenommen die Räume 5, soweit im optischen Element 4 selbst vorgesehen) auf dem Träger 2 auf, so dass der oder die LED-Chips 3 jeweils in einem dann geschlossenen Raum 5 platziert sind.

Wie bereits erwähnt, kann der LED-Chip 3 in einer Ausgestaltungsform in dem Träger 2 eingesetzt sein. Hierbei ist in der Regel eine Ausnehmung 21 (vgl. Figuren 4 und 5) in dem Träger 2 vorgesehen, in die der LED-Chip 3 eingesetzt ist. Die Ausnehmung 21 kann eine Vertiefung 22 in dem Träger 2 aufweisen, so dass der LED-Chip 3 bzgl. der Trägeroberfläche 20 tiefer gelegt vorgesehen ist ("LED-in-Cavity"; vgl. Figur 4). Alternativ kann die Ausnehmung 23 den Träger 2 auch vollständig durchgreifen. In diesem Fall wird im Sinne eines "Board-in-Board"-Aufbaus (vgl. Figur 5) der LED-Chip 3, der in der Regel auf einem zweiten Träger 24 aufgebracht ist, von hinten in die Ausnehmung 23 des (ersten) Trägers 2 eingeführt, bis die beiden Träger 2, 24 vorzugsweise in Anlage miteinander kommen und der LED-Chip 3 somit in dem ersten Träger 2 (genauer in dessen Ausnehmung 23) eingesetzt ist. Die Seitenwände 25 der Ausnehmung 23 können wenigstens teilweise senkrecht (vgl. Figur 4; vgl. auch Figur 5 im unteren Bereich) und/oder stufenförmig (vgl. Figur 4) und/oder vorzugsweise auch schräg (vgl. Figur 5 im oberen Bereich) ausgeführt sein, so dass sich die Ausnehmung 21, 22, 23 von dem LED-Chip 3 weg erweitert. Die Seitenwände 25 der Ausnehmung 21 des Trägers 2 können mit einem reflektierenden Material, z.B. Silber, beschichtet sein und somit als Reflektor dienen.

Die Ausnehmung 21 bildet gemäß einer ersten Ausgestaltungsform alleinig den lichtdurchlässigen Raum 5. In diesem Fall kann das optische Element 4, wie in den Figuren 4 und 5 dargestellt, in vereinfachter Weise als (plane) Platte ausgebildet werden. Wird diese auf die Oberfläche 20 des Trägers 2 gesetzt, begrenzt sie den durch die Ausnehmung 21 bzw. deren Seitenwände 25 gebildeten lichtdurchlässigen Raum 5; genauer begrenzt sie den Raum 5 in einem oberen Bereich desselben. Die LED-Chips 3 sind in diesem Fall vorzugsweise in den Träger 2 eingesetzt, wie in Figuren 4 und 5 dargestellt.

Es ist alternativ jedoch auch denkbar, dass der lichtdurchlässige Raum 5 alleinig durch Ausnehmungen 51 im optischen Element 4 bereitgestellt wird. Die LED-Chips 3 sind dann vorzugsweise auf dem Träger 2 aufgebracht, wie dies in den Figuren 1 bis 3 gezeigt ist. Indem das optische Element 4 auf den Träger 2 platziert wird, wird wenigstens einem oder mehreren LED-Chips 3 eine Ausnehmung 51 und somit ein Raum 5 zugeordnet.

Es ist in einer weiteren alternativen Ausgestaltungsform jedoch auch denkbar, dass die Ausnehmung 21 lediglich einen unteren Bereich des Raumes 5 bildet, welcher sich in der Ausnehmung 51 in dem optischen Element 4 fortsetzt. Die die Ausnehmung 21 begrenzenden Seitenwände 25 derselben bilden folglich einen unteren Bereich der den Raum 5 bildenden Begrenzungswände 50, welche sich in den Seitenwänden 52 der Ausnehmung 51 ebenfalls in dem optischen Element 4 fortsetzen. Der lichtdurchlässige Raum 5 oberhalb des LED-Chips 3 kann folglich nicht nur durch eine Ausnehmung 51 im optischen Element 4 gebildet werden, sondern alternativ oder zusätzlich auch dadurch, dass der LED-Chip 3, welcher auf dem Träger 2 montiert wird bzw. in diesen eingesetzt ist, tiefer liegt als die Oberfläche 20 des Trägers 2, auf welchem das optische Element 4 platziert ist. Bei letztgenannter Ausgestaltungsform kann der Raum 5 wiederum entweder nur durch die Ausnehmung 21 im Träger 2 oder durch die Ausnehmung 51 im optischen Element 4 und die Ausnehmung 21 im Träger 2 gebildet werden. Diese Ausgestaltungsformen lassen insbesondere einen "Board-inBoard"-Aufbau sowie einen "LED-in-Cavity" Aufbau ggf. mit vereinfachtem Aufbau des optischen Elements 4 als Platte zu.

Die Ausgestaltung des Raumes 5 kann zusammenfassend wie folgt beschrieben werden. Das optische Element 4 weist wenigstens eine Ausnehmung 51 auf, wobei die Ausnehmung 51 wenigstens einen oberen Bereich des Raumes 5 bildet und die die Ausnehmung 51 begrenzenden Seitenwände 52 wenigstens einen oberen Bereich der den Raum 5 bildenden Begrenzungswände 50 bilden. Alternativ oder zusätzlich kann der LED-Chip 3 in eine Ausnehmung 21 in dem Träger 2 eingesetzt sein, wobei die Ausnehmung 21 wenigstens einen unteren Bereich des Raumes 5 bildet und die die Ausnehmung 21 begrenzenden Seitenwände 25 derselben wenigstens einen unteren Bereich der den Raum 5 bildenden Begrenzungswände 50 bilden.

Der Raum 5 wird folglich durch die Begrenzungswände 50 gebildet, welche wiederum durch die Seitenwänden 52 des optischen Elements 4 und/oder durch die Seitenwände 25 der Ausnehmung 21 im Träger 2 gebildet werden. Die Begrenzungswände 50 bilden folglich die Oberfläche der Räume 5. Insbesondere ausgehend von dem Träger 2 erstrecken sich die Begrenzungswände 50 bzw. Seitenwände 52 im optischen Element 4 vorzugsweise pyramidenförmig oder kegelförmig (vgl. Figuren 1 bis 3) oder kuppelförmig von dem Träger 2 weg und laufen mit zunehmendem Abstand von dem LED-Chip 3 bzw. dem Träger 2 zusammen. Es ist jedoch auch denkbar, dass die Begrenzungswände 50 einen anderen Oberflächenverlauf aufweisen bzw. der Raum 5 anders ausgebildet ist. So kann der Raum bspw. auch zylindrisch sein und/oder einen eckigen (dreieckigen rechteckigen, quadratischen, mehreckigen) Querschnitt haben. Des Weiteren können, sollten Ausnehmungen 21 im Träger 2 sowie Ausnehmungen 51 im optischen Element 4 zusammen die Begrenzungswände 50 bilden, diese miteinander fluchtend ausgebildet sein; also insbesondere fließend ineinander übergehen und vorzugsweise die gleiche Querschnittsform wenigstens im Übergangsbereich haben. Es ist jedoch auch denkbar, dass die der Trägeroberfläche 20 zugewandten Enden der Ausnehmungen 21, 51 andere Querschnittsformen und/oder Dimensionen haben. Beispielsweise kann die dem Träger 2 zugewandte Öffnung der Ausnehmung 51 größer als die in der Oberfläche 20 des Trägers 2 ausgebildete Öffnung der Ausnehmung 21 sein, sodass die Öffnung der Ausnehmung 51 im optischen Element 4 die Öffnung der Ausnehmung 21 im Träger 2 seitlich umgibt. Die Erfindung ist jedoch nicht auf die vorgenannten Ausgestaltungsformen beschränkt.

Die den Raum 5 bildenden Begrenzungswände 50, also die Seitenwände 52 der Ausnehmung 51 des optischen Elements 4 und/oder die Seitenwände 25 der Ausnehmung 21 im Träger 2, können ferner eine Strukturierung zur verbesserten Einkopplung des von den LEDs 3 emittierten Lichts in das optische Element 4 aufweisen. Die Begrenzungswände 50 weisen eine Linsenfunktion auf und sind erfindungsgemäß in Form einer Fresnel-Linse strukturierte. Es ist auch denkbar, dass die Oberfläche der Räume 5, also die Begrenzungswände 50, wenigstens teilweise semipermeabel gegenüber sichtbaren Lichts ausgeführt ist/sind. Die Begrenzungswände 50 können teilweise, insbesondere in einem Bereich der Seitenwände 25 der Ausnehmung 21 des Trägers 2, mit einem reflektierenden Material, z.B. Silber, beschichtet sein und somit als Reflektor dienen.

Der Raum 5 kann vorzugsweise einen Hohlraum aufweisen, also z.B. ein Vakuum bilden oder mit einem Gas oder Gasgemisch (z.B. Luft) gefüllt sein. Somit kann der LED-Chip 3 von dem optischen Element 4 durch einen ("Luft"-)Spalt räumlich getrennt sein. Es ist alternativ auch denkbar, dass der Raum 5 mit einem lichtdurchlässigen Material gefüllt ist, vorzugsweise mit Silikon. In dem Silikon können bspw. Streupartikel oder Farbkonversionspartikel vorgesehen sein.

Das optische Element 4 weist vorzugsweise Farbkonversionspartikel (d.h. Leuchtstoffe bzw. Luminophore) auf, um bspw. das Licht einer blauen LED 3 bei Verwendung bspw. gelblicher Farbkonversionspartikel auf herkömmlich Weise in weißes Licht umzuwandeln. Die Konzentration dieser Farbkonversationspartikel in dem optischen Element 4 kann konstant sein, also die Farbkonversationspartikel können homogen in dem optischen Element 4 verteilt sein. Es ist jedoch auch denkbar, dass die Konzentration der Farbkonversionspartikel in dem optischen Element 4 nicht konstant ist; in diesem Fall sind die Farbkonversionspartikel vorzugsweise gezielt inhomogen in dem optischen Element 4 verteilt, um eine Farbkonversion entsprechend der Abstrahlcharakteristik des LED-Chips 3 zu ermöglichen und bspw. homogenes Weißlicht über die gesamte abstrahlende Fläche des LED-Moduls 1, also insbesondere die dem LED-Chip 3 gegenüberliegende Seite bzw. Fläche 40 des optischen Elements 4, zu erzeugen.

Um eine homogenen Lichtabstrahlung des LED-Moduls 1 über seine Abstrahlfläche (insbesondere die Oberfläche 40 des optischen Elements 4) trotz der intensiven Abstrahlung der LED-Chips 3 in deren Hauptabstrahlrichtung, also insbesondere in einer Richtung senkrecht zur Oberfläche 30 des LED-Chips 3 (die in der Regel einer Richtung im Wesentlichen senkrecht zur Oberfläche 20 des Trägers 2 entspricht), zu ermöglichen, schlägt die vorliegende Erfindung unterschiedliche Lösungen vor, die einzeln oder auch in Kombination zusammen vorliegen können.

Gemäß einem ersten Ausführungsbeispiel der Erfindung können, wie in Figur 1 gezeigt, auf einer von dem LED-Chip 3 abgewandten Seite 40 des optischen Elements 4 und wenigstens in einem zur Oberfläche 30 des LED-Chips 3 in einer vorzugsweise dazu senkrechten Hauptabstrahlrichtung H gesehen fluchtenden Oberflächenbereich 41 des LED-Moduls 1 wenigstens ein reflektierendes Element 6 gezielt vorgesehen sein. Das bzw. die reflektierenden Elemente 6 sind dabei derart ausgebildet, dass sie insbesondere das in Hauptabstrahlrichtung H des LED-Chips 3 emittierte Licht desselben, welches eine besonders hohe Intensität aufweist, in das optische Element 4 gerichtet, gezielt oder vorzugsweise streuend zurückreflektieren, welches sich somit homogen mit den restlichen Lichtanteilen der LED-Chips 3 durchmischt. Das in Hauptabstrahlrichtung H emittierte Licht des LED-Chips 3 wird somit vorzugsweise über das gesamte optische Element 4 gleichmäßig verteilt, was eine insgesamt homogene Lichtverteilung zur Folge hat, so dass letztlich eine homogene Lichtabstrahlung des LED-Moduls 1 erzielt wird. Mittels der reflektierenden Elemente 6 werden somit sowohl die Intensität des austretenden Lichts als auch der Farbort homogen (vorzugsweise MacAdam 3) über die gesamte abstrahlende Fläche (insbesondere die Oberfläche 40 des optischen Elements 4) verteilt.

Sind, wie gemäß dem dritten und vierten Aspekt definiert, keine LED-Chips 3 vorgesehen, so kann das Vorsehen der reflektierenden Elemente 6 wie folgt beschrieben werden: das wenigstens eine reflektierende Element 6 ist dann auf einer von dem Träger 2, insbesondere einer den LED-Chip 3 aufnehmenden Oberfläche 20 des Trägers 2, abgewandten Seite des optischen Elements 4 und wenigstens in einem oberhalb des Raumes 5 bezüglich des Trägers 2 angeordneten Oberflächenbereich 41, insbesondere in einem zu einer Oberfläche 30 eines vorzusehenden LED-Chips 3 in einer vorzugsweise dazu senkrechten Hauptabstrahlrichtung H - also vorzugsweise im Wesentlichen senkrecht zur Oberfläche 20 des Trägers 2 - gesehen fluchtenden Oberflächenbereich 41, derart vorgesehen, dass eine Abstrahlung eines entsprechend vorzusehenden LED-Chips 3 in Hauptabstrahlrichtung H vorzugsweise über das gesamte optische Element 4 gleichmäßig verteilt wird, um eine homogene Lichtabstrahlung zu erzielen.

Die reflektierenden Elemente 6 können aus hochreflektierenden Materialien hergestellt sein, wie beispielsweise aus einem Metallmaterial, z.B. Aluminium, Silber oder Chrom, oder aus einem anderen reflektierenden Material, wie z.B. keramischer Tinte, weißem Silikon (bspw. aufweisend Titandioxid-Pigmente) oder Bariumtitanat. Die reflektierenden Elemente 6 können dazu als separate Bauteile vorliegen, welche auf dem optischen Element 4 bspw. durch Kleben aufgebracht sind. In diesem Fall können die reflektierenden Elemente bspw. mikrostrukturierte Folien aufweisen, welche auf der Oberfläche 40 des optischen Elements 4 vorgesehen sind.

Alternativ ist es auch denkbar, dass die reflektierenden Elemente 6 als Beschichtung auf der dem LED-Chip 3 bzw. der Trägeroberfläche 20 abgewandten Oberfläche 40 des optischen Elements 4 aufgebracht sind. In beiden Fällen können die reflektierenden Elemente 6 durch einen Leiterplattenhersteller mittels bekannter Methoden aufgebracht bzw. vorgesehen werden.

Die von dem LED-Chip 3 bzw. der Trägeroberfläche 20 abgewandte Seite bzw. Oberfläche 40 des optischen Elements 4 kann ferner plan oder strukturiert ausgebildet sein. Ist die Oberfläche 40 strukturiert ausgebildet, so ist die Strukturierung wiederum vorzugsweise derart ausgebildet, dass die Oberfläche 40 des optischen Elements 4 hierdurch geneigte, konvexe oder konkave Bereiche aufweist. Die reflektierenden Elemente 6 können dann vorzugsweise auf wenigstens einem Teil der strukturierten Oberflächenbereiche aufgebracht bzw. vorgesehen werden, beispielsweise durch Beschichten oder Kleben, wie zuvor bereits beschrieben. Folglich weisen die reflektierenden Elemente 6 entsprechend der strukturierten Oberfläche ebenso geneigte, konvexe oder konkave reflektierende Oberflächen 60 auf.

Ist die Oberfläche 40 des optischen Elements 4 plan ausgebildet, so kann die dem LED-Chip 3 bzw. der Trägeroberfläche 20 zugewandte reflektierende Oberfläche 60 des reflektierenden Elements 6 gezielt optisch vorteilhaft ausgebildet sein; also bspw. eine konkave, konvexe oder geneigte Form aufweisen. Auf diese Weise kann auch ohne Strukturierung der Oberfläche 40 des optischen Elements 4 eine gezielte Reflexion insbesondere des in Hauptabstrahlrichtung H des LED-Chips 3 emittierten Lichts desselben erfolgen.

Auf einer von dem LED-Chip 3 bzw. der Trägeroberfläche 20 abgewandten Seite 40 des optischen Elements 4 in Oberflächenbereichen 42 des LED-Moduls 1, welche nicht mit der Oberfläche 30 des LED-Chips 3 in Hauptabstrahlrichtung H gesehen fluchten bzw. nicht oberhalb des Raumes 5 bzgl. des Trägers 2 angeordnet sind, sind keine reflektierenden Elemente vorgesehen. Auf diese Weise wird eine ausreichende Abstrahlfläche des LED-Moduls 1 bereitgestellt, während das Licht insbesondere in einem intensiven Abstrahlbereich des LED-Chips 3 zur homogenen Lichtabstrahlung des LED-Moduls 1 in das optische Element 4 zurückreflektiert und vorzugsweise gestreut wird. Alternativ ist es vorzugsweise auch denkbar, dass in den vorgenannten Oberflächenbereichen 42 reflektierende Elemente 61, 62 mit jeweils oder insgesamt verringertem Anteil an reflektierender Oberflächen 60 gegenüber den reflektierenden Elementen 6 in dem zur Oberfläche 30 des LED-Chips 3 in Hauptabstrahlrichtung H gesehen fluchtenden bzw. oberhalb des Raumes 5 angeordneten Oberflächenbereich 41 vorgesehen sind. Somit wird einer besonders homogenen Durchmischung des Lichts Rechnung getragen, während gleichzeitig eine große Abstrahlfläche des LED-Moduls 1 zur Verfügung gestellt wird. Die weiteren reflektierenden Elemente 61, 62 weisen hierzu besonders vorzugsweise mit zunehmendem Abstand zu einer sich in Hauptabstrahlrichtung H erstreckenden (bzw. zu einer senkrecht auf dem Träger 2 stehenden und vorzugsweise den Raum 5 mittig durchkreuzenden) Achse A eine abnehmende reflektierende Oberfläche 63, 64 auf.

Dies ist den Figuren 1 bis 3 auch deutlich zu entnehmen, in denen das reflektierende Hauptelement 6 eine vergleichsweise große reflektierende Oberfläche 60 aufweist, die vorzugsweise wenigstens so groß wie die Oberfläche 30 des (vorgesehenen bzw. vorzusehenden) LED-Chips 3 ist, besonders vorzugsweise sogar größer, bspw. doppelt so groß. Das orthogonal zur Achse A gesehen nach dem reflektierenden Hauptelement 6 nächste reflektierende (Zweit-Element 61 hat eine deutlich kleinere reflektierende Oberfläche 63, und das dann folgende reflektierende (Dritt-)Element 62 hat eine wiederum kleinere reflektierende Oberfläche 64 als das reflektierende (Zweit-)Element 61. Die reflektierende Oberfläche 63 des (Zweit-)Elements 61 kann dabei ein Viertel der reflektierenden Oberfläche 60 des Hauptelements 6 aufweisen, wobei wiederum die reflektierende Oberfläche 64 des (Dritt-)Elements 61 vorzugsweise die Hälfte der reflektierenden Oberfläche 62 des Hauptelements 6 aufweist. Vorzugsweise ist die gesamte reflektierende Oberfläche 63, 64 der weiteren reflektierenden Elemente 61, 62 kleiner als die reflektierende Oberfläche 60 des reflektierenden Elements 6. Es sei angemerkt, dass die Erfindung weder auf die Anzahl der (weiteren) reflektierenden Elemente 6, 61, 62 noch auf die Größenverhältnisse derselben beschränkt ist, solange diese eine ausreichend homogene Durchmischung und anschließende Auskopplung des von dem LED-Chip 3 emittierten Lichts ermöglichen.

Wenn gemäß einer bevorzugten Ausgestaltungsform die Oberfläche 20 des Trägers 2 reflektierend ausgebildet ist, kann ein Großteil des durchmischten Lichts (also Primärlicht direkt von dem LED-Chip 3 und Sekundärlicht, welches von den reflektierenden Elementen 6, 61, 62 reflektiert oder im optischen Element 4 wie nachfolgend beschrieben gestreut wurde) (zurück) in Abstrahlrichtung des LED-Moduls 1, also zu der Abstrahlfläche (insbesondere der Oberfläche 40 des optischen Elements 4) hin gelenkt und dort gleichmäßig verteilt ausgekoppelt werden, was eine homogene Lichtabstrahlung bei gleichzeitig besonders hohem Wirkungsgrad des LED-Moduls 1 bedeutet.

Es sei angemerkt, dass auch das optische Element 4 der vierten und fünften Ausführungsform der Figuren 4 und 5 gemäß der vorhergehenden Beschreibung ausgebildet und mit entsprechenden reflektierenden Elementen 6, 61, 62 in gleicher Weise versehen sein kann. Das zuvor Gesagte lässt sich somit in gleicher Weise auf ein LED-Modul 1 gemäß der vierten und fünften Ausführungsform anwenden. Des Weiteren kann der Träger 2 mit dem Optischen Element 4 erfindungsgemäß auch ohne LED-Chip 3 (aber dafür geeignet) ausgebildet sein und ist folglich von der Erfindung mit umfasst. Auf vorgenannte Ausführungen wird diesbezüglich verwiesen.

Das optische Element 4 kann Streupartikel aufweisen, welche die Streuung des von dem (vorgesehenen bzw. vorzusehenden) LED-Chip 3 emittierten Licht in dem optischen Element 4 und somit eine homogene Durchmischung, also Lichtverteilung desselben bewirkt. Die Streupartikel können hierzu homogen in dem optischen Element (4) verteilt angeordnet sein.

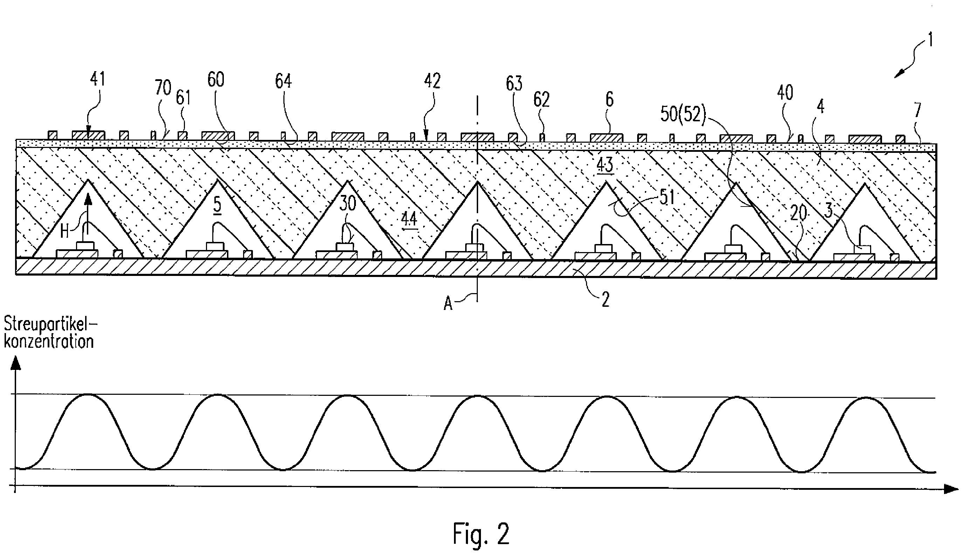

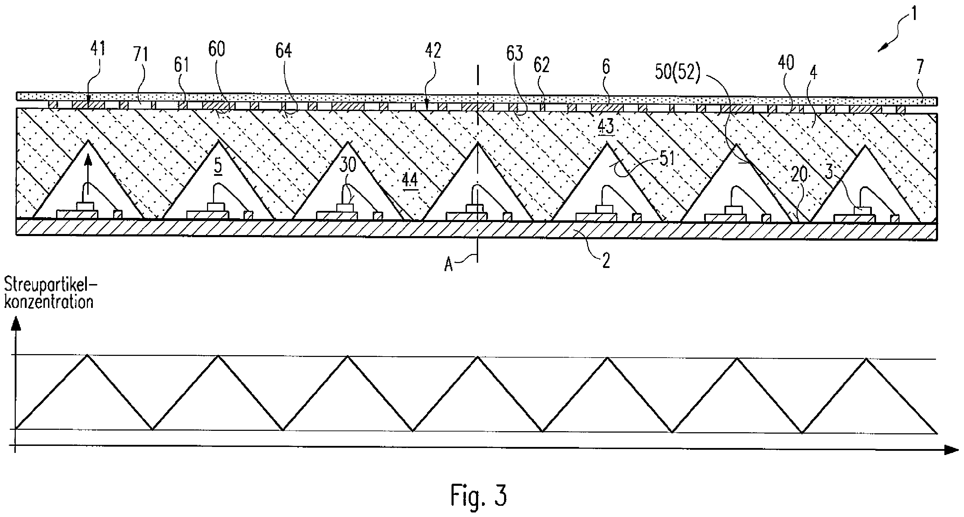

Alternativ zu den reflektierenden Elementen (vgl. Figuren 4 und 5) oder zusätzlich zu diesen, wie bspw. in dem zweiten und dritten Ausführungsbeispielen der Figuren 2 und 3 gezeigt, kann die Konzentration der Streupartikel in einem zur Oberfläche 30 des LED-Chips 3 in vorzugsweise dazu senkrechter Hauptabstrahlrichtung H gesehen fluchtenden Bereich 43 des optischen Elements 4 höher sein als in einem Bereich bzw. Bereichen 44, welche(r) nicht mit der Oberfläche 30 des LED-Chips 3 in Hauptabstrahlrichtung H gesehen fluchtet/fluchten. Da insbesondere in einem Bereich 43 der intensiven Abstrahlung des von dem LED-Chip 3 emittierten Lichts, nämlich in Bereichen 43 des optischen Elements 4, die entlang der Hauptabstrahlrichtung H angeordnet sind, die Konzentration der Streupartikel erhöht ist, kann eine besonders homogene Durchmischung des Lichts in dem optischen Element 4 und vor der Auskopplung desselben aus dem LED-Modul 1 ermöglicht werden.

Sind, wie gemäß dem dritten und vierten Aspekt definiert, keine LED-Chips 3 vorgesehen, so kann die Konzentration der Streupartikel bevorzugt wie folgt definiert werden: die Konzentration der Streupartikel ist dann in einem Bereich 43 oberhalb des Raumes 5 bezüglich des Trägers 2, insbesondere in einem Bereich 43, der mit einer Oberfläche 30 eines vorzusehenden LED-Chips 3 in einer vorzugsweise dazu senkrechten Hauptabstrahlrichtung H - also vorzugsweise im Wesentlichen senkrecht zur Oberfläche 20 des Trägers 2 - gesehen fluchtet, höher als in einem Bereich 44, welcher nicht oberhalb des Raumes 5 bezüglich des Trägers 2 angeordnet ist, insbesondere welcher nicht mit der Oberfläche 30 des vorzusehenden LED-Chips 3 in Hauptabstrahlrichtung H gesehen fluchtet, um eine homogene Lichtabstrahlung zu erzielen.

Das gezielte Vorsehen von Streupartikeln in der vorgenannten Weise führt zu einer homogenes Licht emittierenden Oberfläche 40 des optischen Elements 4, so dass sowohl die Intensität des austretenden Lichts als auch der Farbort homogen (vorzugswiese MacAdam 3) über die gesamte abstrahlende Fläche des LED-Moduls 1 verteilt ist. Das vorteilhafte Ausbilden eines hochreflektiven Trägers 2 trägt zu einer homogenen Durchmischung sowie einem hohen Wirkungsgrad des LED-Moduls 1 bei. Durch das gezielt konzentrierte Vorsehen von Streupartikeln in dem optischen Element 4 wird es ermöglicht, dass auch bei Abwesenheit der vorbeschriebenen reflektierenden Elemente 6, 61, 62 (bspw. gemäß Figuren 4 und 5) eine homogene Lichtverteilung ermöglicht wird, so dass homogenes (Weiß-)Licht aus dem LED-Modul 1 ausgekoppelt bzw. abgestrahlt werden kann.

Die Figuren 2 bis 5 zeigen weiterhin eine unter dem LED-Modul 1 dargestellte Funktion, die beispielhaft die Konzentration der Streupartikel über die Breite der optischen Platte 4 gesehen, also insbesondere quer zu einer Hauptabstrahlrichtung H des LED-Chips 3, darstellt. Eine Änderung der Streupartikelkonzentration über die Breite des optischen Elements 4 kann dabei beispielswiese fließend, wellenförmig, sinusförmig, stufenförmig und/oder sprunghaft und/oder in einer anderen Weise gleichmäßig oder ungleichmäßig verteilt vorgesehen werden.

Wie in den Figuren 2 und 3 gezeigt ist es denkbar, dass das optische Element 4 keine Farbkonversionspartikel aufweist. In diesem Fall oder auch in einem Fall, in dem das optische Element 4 lediglich gewisse Leuchtstoffe aufweist und weitere vorgesehen werden sollen, oder in einem Fall, in dem zusätzlich zu den in dem optischen Element 4 vorgesehenen Farbkonversionspartikeln weitere vorgesehen werden sollen, kann eine weitere Schicht oder Platte 7 mit Farbkonversionspartikeln vorgesehen werden.

Die Schicht bzw. Platte 7 weist somit Farbkonversionspartikel zusätzlich oder alternativ zu den in dem optischen Element 4 vorgesehenen Farbkonversionspartikeln auf. Die Farbkonversionsplatte oder Farbkonversionsschicht 7 weist vorzugsweise eine im Wesentlichen durchgehend grünlich/gelbliche Platte bzw. Schicht 7 auf. Vorzugsweise weist das optische Element 4 grünlich/gelbliche Leuchtstoffe auf, wobei die Farbkonversionsplatte oder Farbkonversionsschicht 7 vorzugsweise punktuell, besonders vorzugsweise unmittelbar oberhalb des LED-Chips 3 vorzugsweise in Hauptabstrahlrichtung H gesehen bzw. oberhalb des Raumes 5 bzgl. des Trägers 2, separierte Bereiche eines rötlich emittierenden Leuchtstoffs aufweisen, um die Abstrahlcharakteristik gezielt zu steuern und insbesondere eine homogene Weißlichtabgabe zu erzielen.

Auch der rot emittierende Leuchtstoff wird durch das vorzugsweise blaue Licht des LED-Chips 3 angeregt, genauer gesagt durch den Anteil, der von dem vorzugsweise gelb/grünen Leuchtstoff durchgelassen wird. Alternativ ist auch, wie zuvor beschrieben, eine Anregung durch gelblich/grünliches Licht vorstellbar. Es ist zudem denkbar, dass die Farbkonversionsplatte oder Farbkonversionsschicht 7 mehrere Lagen von Schichten aufweist, wobei bspw. eine gelblich/grünliche Schicht vorgesehen ist, der in Abstrahlrichtung des LED-Moduls 1 eine vorbeschriebene, mit rötlich emittierenden Leuchtstoff versehene Schicht nachgelagert ist, welche vorzugsweise miteinander verbunden sind.

Neben Farbkonversionspartikeln ist es auch denkbar, dass die Farbkonversionsplatte oder Farbkonversionsschicht 7 zusätzlich Streupartikel aufweist. Sind also bspw. reflektierende Elemente 6, 61, 62 zur homogenen Lichtverteilung vorgesehen, so kann bei Verwendung einer Farbkonversionsplatte oder Farbkonversionsschicht 7 bspw. vollständig auf Farbkonversionspartikel und Streupartikel in dem optischen Element 4 verzichtet werden, es kann jedoch auch wenigstens eines der vorgenannten in dem optischen Element 4 in vorbeschriebener Weise vorgesehen sein.

Die Farbkonversionsplatte oder Farbkonversionsschicht 7 ist vorzugsweise in Hauptabstrahlrichtung H des LED-Chips 3 gesehen bzw. bezüglich des Trägers 2 oberhalb des Raumes 5 oberhalb des optischen Elements 4 vorgesehen; bildet also einen sogenannte "Remote Phosphor Layer". Die Farbkonversionsplatte oder Farbkonversionsschicht 7 erstreckt sich im Wesentlichen über die gesamte Oberfläche 40 des optischen Elements 4 und schließt vorzugsweise bündig mit den Randbereichen des optischen Elements ab. Es ist jedoch auch denkbar, dass die Farbkonversionsplatte oder Farbkonversionsschicht 7 lediglich einen Teilbereich der Oberfläche 40 des optischen Elements 4 abdeckt; also bspw. einem bestimmten LED-Chip 3 oder einer bestimmten Gruppe von LED-Chips 3 zugeordnet ist.

Die Farbkonversionsplatte oder Farbkonversionsschicht 7 kann gemäß einer ersten Ausgestaltungsform auf der dem LED-Chip 3 abgewandten Oberfläche 40 des optischen Elements 4 vorgesehen sein, wie dies in Figur 2 gezeigt ist. Hierzu liegt die Farbkonversionsplatte oder Farbkonversionsschicht 7 vorzugsweise flächig auf dem optischen Element 4 auf und ist bspw. auf diesem mittels eines Klebers befestigt.

Wie zuvor bereits erwähnt, können bei Vorliegen von gezielt verteilten Streupartikeln in dem optischen Element 4, wie bspw. in Figur 2 gezeigt, optional zusätzlich reflektierenden Elemente 6, 61, 62 vorgesehen sein. In diesem Fall können, wenn die Farbkonversionsplatte oder Farbkonversionsschicht 7 auf der Oberfläche 40 des optischen Elements 4 vorgesehen ist, auf der dem optischen Element 4 abgewandten Oberfläche 70 der Farbkonversionsplatte oder Farbkonversionsschicht 7 die reflektierenden Elemente 6, 61, 62 in der gleichen Weise wie auf dem optischen Element 4 vorgesehen sein. Die Oberfläche 70 kann also plan oder strukturiert ausgebildet sein. Im Übrigen wird auf die vorherige Beschreibung bzgl. der reflektierenden Elemente 6, 61, 62 verwiesen, die in gleicher Weise für das Vorsehen derselben auf der Oberfläche 70 der Farbkonversionsplatte oder Farbkonversionsschicht 7 anzuwenden ist.

Gemäß einer weiteren Ausgestaltungsform ist es auch denkbar, dass die Farbkonversionsplatte oder Farbkonversionsschicht 7 auf den auf der dem LED-Chip 3 bzw. dem Träger 2 abgewandten Oberfläche 40 des optischen Elements 4 vorgesehenen reflektierenden Elementen 6, 61, 62 vorgesehen ist, wie in Figur 3 gezeigt. Hierzu ist die dem optischen Element 4 abgewandte Seite der reflektierenden Elemente 6, 61, 62 vorzugsweise plan ausgebildet, um der Farbkonversionsplatte oder Farbkonversionsschicht 7 genügend Auflagefläche zu deren Befestigung bereitzustellen. Der Zwischenraum 71 zwischen Farbkonversionsplatte oder Farbkonversionsschicht 7 und optischem Element 4 kann ein Hohlraum sein oder alternativ wenigstens teilweise mit einem lichtdurchlässigen oder semipermeablen Material (bspw. Silikon) ausgefüllt sein.

Die Farbkonversionsplatte oder Farbkonversionsschicht 7 kann eine konstante Dicke oder alternativ eine gezielte Profilierung aufweisen. In letzterem Fall ist die Dicke der Farbkonversionsplatte oder Farbkonversionsschicht 7 vorzugsweise in einem zur Oberfläche 30 des LED-Chips 3 in Hauptabstrahlrichtung H gesehen fluchtenden Bereich 41, 43 bzw. einem Bereich 41, 43 oberhalb des Raumes 5 bezüglich des Trägers 2 größer als in den Bereichen 42, 44, welche nicht mit der Oberfläche 30 des LED-Chips 3 in Hauptabstrahlrichtung H gesehen fluchten bzw. nicht oberhalb des Raumes 5 bezüglich des Trägers 2 angeordnet sind. Dies ist insbesondere dann vorteilhaft, wenn keine reflektierenden Elemente 6, 61, 62 vorgesehen sind oder die Farbkonversionsplatte oder Farbkonversionsschicht 7 sandwichartig zwischen optischem Element 4 und den reflektierenden Elementen 6, 61, 62 vorgesehen ist.

Es versteht sich, dass die Farbkonversionsschicht 7 in der vorbeschriebenen Weise mit und ohne entsprechende reflektierenden Elemente 6, 61, 62 auch in den Ausführungsformen der Figuren 1, 4 und 5 vorgesehen sein können.

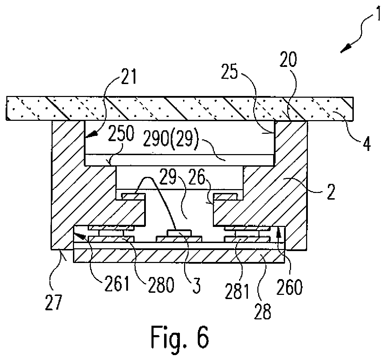

Alternativ zu der Ausgestaltungsform der Figur 4 zeigt Figur 6 eine sechste Ausführungsform, welche im Wesentlichen mit derjenigen der vierten Ausführungsform der Figur 4 übereinstimmt. Insofern wird auf obige Ausführungen vollumfänglich verwiesen und im Folgenden lediglich die Unterschiede zur vierten Ausführungsform beschrieben.

In Abänderung von Figur 4 weist das LED-Modul 1 bzw. der Träger 2 eine Ausnehmung 26 an deren Unterseite 27 - also der der Trägeroberfläche 20 gegenüberliegenden Seite - auf, welche vergleichbar der durchgreifenden Ausnehmung 23 der Figur 5 ist. Vorzugsweise weist die Ausnehmung 26 jedoch einen größeren Durchmesser als die Ausnehmung 23 auf, um insbesondere eine elektrische Kontaktierung zwischen dem (ersten) Träger 2 und einem weiteren, im Folgenden beschriebenen Träger 28 zu ermöglichen. Die Ausnehmung 26 weist folglich von der Unterseite 27 in Richtung der Trägeroberfläche 20 gesehen einen sich in Form einer Stufe 260 sprunghaft verjüngenden Durchmesser auf. In die Ausnehmung 26 an der Unterseite 27 des Trägers 2, vorzugsweise in deren breiteren Bereich 261, ist/wird der vorgenannte zweiter Träger 28 eingesetzt, wobei die Außenkontur des zweiten Trägers 28 mit der Innenkontur der Ausnehmung 26 vorzugsweise derart korrespondiert, dass sie in Form einer Presspassung zusammengefügt/zusammenfügbar sind und somit dicht miteinander abschließen. Dies bietet den Vorteil, dass eine applizierte Phosphorschicht 29 (ein sogenannter "Damm & Fill") zur Farbkonversion am Ausrinnen gehindert wird.

Der zweite Träger 28 ist vorzugsweise eine Leiterplatte, insbesondere eine IMS-Leiterplatte oder auch eine FR4-Leiterplatte, CEM x oder LiD ("LED in Cavity") Leiterplatte oder dergleichen. Mit dem zweiten Träger 28 kann zugleich auch der darauf vorgesehene bzw. vorzusehende LED-Chip 3 in dem ersten Träger 2 sicher positioniert werden.

Die "Damm & Fill" Phosphorschicht 29 kann entweder selbst Konversionspartikel enthalten oder vorzugsweise auch transparent - ohne Konversionspartikel - ausgebildet sein; beispielsweise also ausschließlich aus Silikon hergestellt sein. In letztgenanntem Fall ist die "Damm & Fill" Phosphorschicht ferner mit einer Phosphorschicht 290 als "Remote Layer" ausgebildet bzw. versehen, welche dann die Farbkonversion bewirkt. Um eine derartige "Remote Layer" Phosphorschicht 290 sicher vorsehen zu können, sind die Seitenwände 25 der Ausnehmung 21 vorzugsweise gestuft ausgebildet. Hierzu verbreitert sich der Durchmesser der Seitenwände 25 von dem zweiten Träger 28 aus zur Trägeroberfläche 20 hin gesehen vorzugsweise sprunghaft und bildet somit eine Stufe 250 aus, auf die die "Remote Layer" Phosphorschicht 290 aufgesetzt und befestigt werden kann.

Zur elektrischen Kontaktierung sind der erste und der zweite Träger 2, 28 bzw. deren entsprechend vorgesehene Kupferkontakte 280 mittels "solider" (Lötmittel) oder "adhesive" (Klebemittel) 281 verbunden.

Die Ausgestaltung der Figur 6 kann in gleicher Weise auch auf die Figur 5 angewendet werden, wobei die Seitenwände 25 dann abgeschrägt ausgebildet sind. Zum Vorsehen einer eventuellen "Remote Layer" Phosphorschicht 290 kann ebenfalls eine Stufe 250 in die schrägen Seitenwände 25 eingebracht sein oder die umlaufende Stirnfläche der "Remote Layer" Phosphorschicht 290 kann entsprechend der schrägen Seitenwände 25 abgeschrägt ausgebildet sein. Im Übrigen wird auf obige Ausführungen verwiesen.

Im Folgenden wird ein Verfahren zum Aufbau des erfindungsgemäßen LED-Moduls 1 beschrieben.

Zunächst wird ein Träger 2 bereitgestellt, welcher vorzugsweise entweder aus einem reflektierenden Material besteht oder mit einer reflektierenden Schicht beschichtet wird. Auf dem oder in den Träger 2 werden sodann LED-Chips 3 in bekannter Weise befestigt; also bspw. aufgebracht (Figuren 1 bis 3) oder eingesetzt (Figuren 4 und 5). Auf den Träger 2 wird dann ein optisches Element 4 derart aufgesetzt und mit diesem vorzugsweise verbunden (bspw. durch Kleben, Schrauben und dergleichen), dass oberhalb eines jeden oder einer Gruppe von LED-Chips 3 ein hohler oder gefüllter lichtdurchlässiger Raum 5 vorgesehen ist, welcher die (Gruppe von) LED-Chips 3 umgibt bzw. den Raum 5 begrenzt. Der Raum 5 kann entweder durch wenigstens eine Ausnehmung 51 in dem optischen Element 4, oder durch wenigstens eine Ausnehmung 21 in dem Träger 2, oder sowohl durch eine Ausnehmung 51 in dem optischen Element 4 und eine Ausnehmung 21 in dem Träger 2 gebildet werden. In letztgenanntem Fall können die Ausnehmungen 51, 21 zu dem Raum 5 verbunden sein und somit den Raum 5 bilden. Das optische Element 4 kann homogen oder gezielt verteilt angeordnete Streupartikel oder Farbkonversionspartikel aufweisen. Insbesondere in einem Fall, in dem keine oder keine gezielt verteilten Streupartikel im optischen Element 4 vorgesehen sind, können reflektierende Elemente 6, 61, 62 in der vorbeschriebenen Art auf dem optischen Element 4 vorgesehen sein. Des Weiteren kann auf den reflektierenden Elementen 6, 61, 62 oder zwischen diesen und dem optischen Element sandwichartig eine Farbkonversionsplatte oder Farbkonversionsschicht 7 vorgesehen werden, welche vor allem Farbkonversionspartikel aber auch Streupartikel aufweisen kann. Insbesondere in einem Fall, in dem (gezielt verteilte) Farbkonversionspartikel in dem optischen Element 4 vorgesehen sind, muss nicht zwingend eine Farbkonversionsplatte oder Farbkonversionsschicht 7 auf dem optischen Element 4 vorgesehen werden. Andererseits kann bei Vorliegen von gezielt konzentriert angeordneten Streupartikeln im optischen Element 4 die Farbkonversionsplatte oder Farbkonversionsschicht 7 auf dem optischen Element 4 vorgesehen sein, ohne zusätzlich reflektierende Elemente 6, 61, 62 vorzusehen.

Die Erfindung ist nicht auf die zuvor beschriebenen Ausführungsbeispiele beschränkt, solange sie vom Gegenstand der folgenden Ansprüche umfasst ist.

## Patentansprüche

1. LED-Modul (1) aufweisend:
- einen Träger (2), insbesondere eine Leiterplatte,
- wenigstens einen auf dem Träger (2) aufgebrachten oder in den Träger (2) eingesetzten LED-Chip (3), und
- ein optisches Element (4), vorzugsweise eine optische Platte, welches einen oberhalb des LED-Chips (3) vorgesehenen, lichtdurchlässigen Raum (5) begrenzt, vorzugsweise umgibt, und welcher Streupartikel aufweist,
wobei die Konzentration der Streupartikel in einem Bereich (43), der mit der Oberfläche (30) des LED-Chips (3) in einer vorzugsweise dazu senkrechten Hauptabstrahlrichtung (H) gesehen fluchtet, höher ist als in einem Bereich (44), welcher nicht mit der Oberfläche (30) des LED-Chips (3) in Hauptabstrahlrichtung (H) gesehen fluchtet, um eine homogene Lichtabstrahlung zu erzielen, wobei die den Raum (5) bildenden Begrenzungswände (50) eine Strukturierung zur verbesserten Einkopplung des von dem LED-Chip (3) emittierten Lichts in das optische Element (4) in Form einer Fresnel-Linse aufweisen.

2. LED-Modul (1) nach Anspruch 1, wobei auf einer von dem LED-Chip (3) abgewandten Seite (40) des optischen Elements (4) und wenigstens in einem zur Oberfläche (30) des LED-Chips (3) in Hauptabstrahlrichtung (H) gesehen fluchtenden Oberflächenbereich (41) wenigstens ein reflektierendes Element (6) vorgesehen ist, so dass die Abstrahlung des LED-Chips (3) in Hauptabstrahlrichtung (H) vorzugsweise über das gesamte optische Element (4) gleichmäßig verteilt wird.

3. LED-Modul (1) aufweisend:
- einen Träger (2), insbesondere eine Leiterplatte,
- wenigstens einen auf dem Träger (2) aufgebrachten oder in den Träger (2) eingesetzten LED-Chip (3), und
- ein optisches Element (4), vorzugsweise eine optische Platte, welches einen oberhalb des LED-Chips (3) vorgesehenen, lichtdurchlässigen Raum (5) begrenzt, vorzugsweise umgibt,
wobei auf einer von dem LED-Chip (3) abgewandten Seite des optischen Elements (4) und wenigstens in einem zur Oberfläche (30) des LED-Chips (3) in einer vorzugsweise dazu senkrechten Hauptabstrahlrichtung (H) gesehen fluchtenden Oberflächenbereich (41) wenigstens ein reflektierendes Element (6) vorgesehen ist, so dass die Abstrahlung des LED-Chips (3) in Hauptabstrahlrichtung (H) vorzugsweise über das gesamte optische Element (4) gleichmäßig verteilt wird, um eine homogene Lichtabstrahlung zu erzielen, wobei die den Raum (5) bildenden Begrenzungswände (50) eine Strukturierung zur verbesserten Einkopplung des von dem LED-Chip (3) emittierten Lichts in das optische Element (4) in Form einer Fresnel-Linse aufweisen.

4. LED-Modul (1) nach Anspruch 3, wobei das optische Element (4) Streupartikel aufweist, und
wobei die Streupartikel entweder homogen in dem optischen Element (4) verteilt angeordnet sind,
oder wobei die Konzentration der Streupartikel in einem zur Oberfläche (30) des LED-Chips (3) in Hauptabstrahlrichtung (H) gesehen fluchtenden Bereich (43) des optischen Elements (4) höher ist als in einem Bereich (44), welcher nicht mit der Oberfläche (30) des LED-Chips (3) in Hauptabstrahlrichtung (H) gesehen fluchtet.

5. LED-Modul (1) nach einem der Ansprüche 2 bis 4, wobei auf einer von dem LED-Chip (3) abgewandten Seite (40) des optischen Elements (4) in bzw. auf Oberflächenbereichen (44), welche nicht mit der Oberfläche (30) des LED-Chips (3) in Hauptabstrahlrichtung (H) gesehen fluchten, keine reflektierenden Elemente oder reflektierende Elemente (61, 62) mit jeweils oder insgesamt verringertem Anteil an reflektierender Oberflächen (63, 64) gegenüber dem reflektierenden Element (6) in dem zur Oberfläche (30) des LED-Chips (3) in Hauptabstrahlrichtung (H) gesehen fluchtenden Oberflächenbereich (41) aufweist, wobei die weiteren reflektierenden Elemente (61, 62) vorzugsweise mit zunehmendem Abstand zu einer sich in Hauptabstrahlrichtung (H) erstreckenden Achse (A) eine abnehmende reflektierende Oberfläche (63, 64) aufweisen.

6. LED-Modul (1) nach einem der Ansprüche 2 bis 5, wobei die reflektierenden Elemente (6, 61, 62) aus hochreflektierenden Materialien hergestellt sind, wie beispielsweise aus einem Metallmaterial, z.B. Aluminium, Silber oder Chrom, aus einem anderen reflektierenden Material wie z.B. keramischer Tinte, weißem Silikon oder Bariumtitanat, oder aus mikrostrukturierten Folien, wobei die reflektierenden Elemente (6, 61, 62) vorzugsweise durch Beschichten der dem LED-Chip (3) abgewandten Oberfläche (40) des optischen Elements (4) oder durch Aufkleben separater reflektierender Elemente (6) aufgebracht sind.

7. LED-Modul (1) nach einem der Ansprüche 2 bis 6, wobei die von dem LED-Chip (3) abgewandte Seite (40) des optischen Elements (4) plan oder strukturiert ausgebildet ist, wobei die Strukturierung vorzugsweise derart ausgebildet ist, dass die Oberfläche (40) des optischen Elements (4) geneigte, konvexe oder konkave Bereiche aufweist, wobei vorzugsweise die reflektierenden Elemente (6, 61, 62) auf den strukturierten Oberflächenbereichen, beispielsweise durch Beschichten oder Kleben, vorgesehen sind, so dass die reflektierenden Elemente (6, 61, 62) geneigte, konvexe oder konkave reflektierende Oberflächen aufweisen.

8. LED-Modul (1) nach einem der vorhergehenden Ansprüche, wobei die den Raum (5) bildenden Begrenzungswände (50, 52) vorzugsweise des optischen Elements (4) sich ausgehend von dem Träger (2) pyramidenförmig, kegelförmig oder kuppelförmig vom Träger (2) weg erstrecken und mit zunehmendem Abstand von dem Träger (2) zusammenlaufen.

9. LED-Modul (1) nach einem der vorhergehenden Ansprüche, wobei das optische Element (4) wenigstens eine Ausnehmung (51) aufweist, wobei die Ausnehmung (51) wenigstens einen oberen Bereich des Raumes (5) bildet und die die Ausnehmung (51) begrenzenden Seitenwände (52) wenigstens einen oberen Bereich der den Raum (5) bildenden Begrenzungswände (50) bilden.

10. LED-Modul (1) nach einem der vorhergehenden Ansprüche, wobei der LED-Chip (3) in eine Ausnehmung (21) in dem Träger (2) eingesetzt ist, wobei die Ausnehmung (21) wenigstens einen unteren Bereich des Raumes (5) bildet und die die Ausnehmung (21) begrenzenden Seitenwände (25) derselben wenigstens einen unteren Bereich der den Raum (5) bildenden Begrenzungswände (50) bilden.

11. LED-Modul (1) nach einem der vorhergehenden Ansprüche, wobei der Raum (5) einen Hohlraum aufweist, welcher den LED-Chip (3) von dem optischen Element (4) räumlich trennt, oder wobei der Raum (5) mit einem lichtdurchlässigen Material gefüllt ist, vorzugsweise mit Silikon.

12. LED-Modul (1) nach einem der vorhergehenden Ansprüche, wobei das optische Element (4) aus einem hochtransparenten Material hergestellt ist, wie beispielsweise aus einem Matrixmaterial, z.B. Epoxidharz, aus Kunststoff oder aus Glas.

13. LED-Modul (1) nach einem der vorhergehenden Ansprüche, wobei das optische Element (4) Farbkonversionspartikel aufweist, welche vorzugsweise homogen oder gezielt inhomogen in dem optischen Element (4) verteilt vorliegen.

14. LED-Modul (1) nach einem der vorhergehenden Ansprüche, wobei in Hauptabstrahlrichtung (H) des LED-Chips (3) gesehen oberhalb des optischen Elements (4) eine weitere Schicht oder Platte (7) vorgesehenen ist, welche Farbkonversionspartikel aufweist, wobei die Farbkonversionsplatte oder Farbkonversionsschicht (7) entweder auf der dem LED-Chip (3) abgewandten Oberfläche (40) des optischen Elements (4) vorgesehen ist und besonders vorzugsweise auf der dem optischen Element (4) abgewandten Oberfläche (70) die reflektierenden Elemente (6, 61, 62) aufweist, oder wobei die Farbkonversionsplatte oder Farbkonversionsschicht (7) auf den auf der dem LED-Chip (3) abgewandten Oberfläche (40) des optischen Elements (4) vorgesehenen reflektierenden Elementen (6, 61, 62) vorgesehen ist.

15. LED-Modul (1) nach Anspruch 12, wobei die Farbkonversionsplatte oder Farbkonversionsschicht (7) eine konstante Dicke oder eine gezielte Profilierung aufweist, wobei die Dicke vorzugsweise in einem zur Oberfläche (30) des LED-Chips (3) in Hauptabstrahlrichtung (H) gesehen fluchtenden Bereich größer ist als in den Bereichen, welche nicht mit der Oberfläche (30) des LED-Chips (3) in Hauptabstrahlrichtung (H) gesehen fluchten.

16. LED-Modul (1) nach Anspruch 14 oder 15 , wobei die Farbkonversionsplatte oder Farbkonversionsschicht (7) eine im Wesentlichen durchgehend grünlich/gelbliche Platte bzw. Schicht (7) aufweist, wobei vorzugsweise punktuell, besonders vorzugsweise unmittelbar oberhalb des LED-Chips (3) vorzugsweise in Hauptabstrahlrichtung (H) gesehen, separierte Bereiche eines rötlich emittierenden Leuchtstoffs angeordnet sind.

17. LED-Modul (1) nach einem der Ansprüche 14 oder 15, wobei die Farbkonversionsplatte oder Farbkonversionsschicht (7) ferner Streupartikel aufweist.

18. LED-Modul (1) nach einem der vorhergehenden Ansprüche, wobei das optische Element (4) durch Kleben, Schrauben oder äußere Verklebung definiert auf der den LED-Chip (3) aufweisenden Seite (20) des Trägers (2) befestigt ist.

19. LED-Modul (1) nach einem der vorhergehenden Ansprüche, wobei die Oberfläche (20) des Trägers (2), auf dem die LED-Chips (3) aufgebracht sind, reflektierend, vorzugsweise hochreflektierend ist, wobei die Reflexionseigenschaft durch das Material des Trägers (2), bspw. Aluminium, eine entsprechende Bearbeitung oder eine Beschichtung des Trägers (2), bspw. mit keramischer Tinte, weißem Lötstopplack oder Silber, erzeugt wird.

20. LED-Modul (1) nach einem der vorhergehenden Ansprüche, wobei der Träger (2) eine Leiterplatte aus Epoxidharz, eine keramische Leiterplatte oder eine Aluminiumkern-Leiterplatte (IMS) ist.

21. LED-Modul (1) nach einem der vorhergehenden Ansprüche, wobei der LED-Chip (3) mittels Nacktchipmontage oder Oberflächenmontage auf dem Träger (2) befestigt ist.

22. LED-Modul (1) nach einem der vorhergehenden Ansprüche, wobei das LED-Modul (1) wenigstens zwei oder mehr LED-Chips (3) aufweist, wobei jeweils einem oder mehreren LED-Chips (3) ein lichtdurchlässiger Raum (5) zugeordnet ist und diese umgibt, und wobei die LED-Chips (3) Licht derselben oder unterschiedlicher Wellenlänge emittieren.

## Claims

1. LED module (1) comprising:
- a carrier (2), in particular a printed circuit board, and at least one LED chip (3) applied to the carrier (2) or inserted in the carrier (2), and
- an optical element (4), preferably an optical plate, which delimits, preferably surrounds, a translucent space (5) provided above the LED chip (3), and which comprisesdiffuser particles,
wherein the concentration of the diffuser particles is higher in a region (43) that is aligned with the surface (30) of the LED chip (3) in a preferably perpendicular main emission direction (H), than in a region (44) which is not aligned with the surface (30) of the LED chip (3) in the main emission direction (H),in order to achieve homogeneous light emission, wherein the boundary walls (50) forming the space (5) comprisestructuring for improved coupling of the light emitted by the LED chip (3) into the optical element (4) that is in the form of a Fresnel lens.

2. LED module (1) according to claim 1, wherein at least one reflective element (6) is provided on aside (40) of the optical element (4) facing away from the LED chip (3) in at least one surface region (41) of the LED chip (3) of the surface (30) aligned in the main emission direction (H), so that the emission from the LED chip (3) in the main emission direction (H) is preferably evenly distributed over the entire optical element (4).

3. LED module (1) comprising:
- a carrier (2), in particular a printed circuit board, and at least one LED chip (3) applied to the carrier (2) or inserted in the carrier (2), and
- an optical element (4), preferably an optical plate, which delimits, preferably surrounds, a translucent space (5) provided above the LED chip (3),
wherein at least one reflective element (6) is provided on a side (40) of the optical element (4) facing away from the LED chip (3) in at least one surface region (41) of the LED chip (3) of the surface (30) aligned in the main emission direction (H), so that the emission from the LED chip (3) in the main emission direction (H) is preferably evenly distributed over the entire optical element (4), in order to achieve homogeneous light emission, wherein the boundary walls (50) forming the space (5) comprises structuring for improved coupling of the light emitted by the LED chip (3) into the optical element (4) that is in the form of a Fresnel lens.

4. LED module (1) according to claim 3, wherein the optical element (4) comprises diffuser particles, and
wherein the diffuser particles are arranged either homogeneously distributed in the optical element (4), or
wherein the concentration of the diffuser particles is higher in a region (43) of the optical element (4) that is aligned with the surface (30) of the LED chip (3) in the main emission direction (H), than in a region (44) that is not aligned with the surface (30) of the LED chip (3) in the main emission direction (H).

5. LED module (1) according to one of the claims 2 to 4, wherein on a side (40) of the optical element (4) facing away from the LED chip (3),in or on the surface regions (44) that are not aligned with the surface (30) of the LED chip (3) in the main emission direction (H), no reflective elements or reflective elements (61, 62) comprise an individual or collective reduced proportion of the reflective surfaces (63, 64) with respect to the reflective element (6) in the surface region (41) aligned with the surface (30) of the LED chip (3) in the main emission direction (H), wherein the further reflective elements (61, 62) preferably comprise a decreasing reflective surface (63, 64) at an increasing distance from an axis (A) extending in the main emission direction (H).

6. LED module (1) according to any one of the claims 2 to 5, wherein the reflective elements (6, 61, 62) are made of highly reflective materials, such as a metal material, e.g. aluminum, silver or chrome, or another reflective material such as ceramic ink, white silicone or barium titanate, or from microstructured films, wherein the reflective elements (6, 61, 62) are preferably applied by coating the surface (40) of the optical element (4) facing away from the LED chip (3), or by adhesive bonding of separate reflective elements (6).

7. LED module (1) according to one of claims 2 to 6, wherein the side (40) of the optical element (4) facing away from the LED chip (3) is flat or structured, wherein the structuring is preferably so formed that the surface (40) of the optical element (4) comprises inclined, convex or concave areas, wherein the reflective elements (6, 61, 62) are preferably provided on the structured surface regions, for example by coating or gluing, so that the reflective elements (6, 61, 62) have inclined, convex or concave reflective surfaces.

8. LED module (1) according to any one of the preceding claims, wherein the boundary walls (50, 52) forming the space (5) preferably extend the optical element (4) in a pyramidal, conical or dome-shaped manner from the carrier (2), starting from the carrier (2), and then converge upon increasing distance from the carrier (2).

9. LED module (1) according to any one of the preceding claims, wherein the optical element (4) has at least one recess (51), wherein the recess (51) forms at least an upper region of the space (5), while the side walls (52) delimiting the recess (51) form at least an upper region of the boundary walls (50) forming the space (5).

10. LED module (1) according to one of the preceding claims, wherein the LED chip (3) is inserted in a recess (21) in the carrier (2), wherein the recess (21) forms at least a lower region of the space (5), while the side walls (25) delimiting the recess (21) form at least one lower region of the boundary walls (50) forming the space (5).

11. LED module (1) according to one of the preceding claims, wherein the space (5) has a hollow space which spatially separates the LED chip (3) from the optical element (4), or wherein the space (5) is filled with a translucent material, preferably with silicone.

12. LED module (1) according to one of the preceding claims, wherein the optical element (4) is made of a highly transparent material, such as a matrix material, e.g. epoxy resin, plastic or glass.

13. LED module (1) according to one of the preceding claims, wherein the optical element (4) comprises color conversion particles which are preferably distributed homogeneously, or selectively inhomogeneously, in the optical element (4).

14. LED module (1) according to one of the preceding claims, wherein a further layer or plate (7) having color conversion particles is provided in the main emission direction (H) of the LED chip (3) above the optical element (4), wherein the color conversion plate or color conversion layer (7) is provided either on the surface (40) of the optical element (4) facing away from the LED chip (3), and particularly preferably comprises the reflective elements (6, 61, 62) on the surface (70) facing away from the optical element (4), or wherein the color conversion plate or color conversion layer (7) is provided on the surface (40) of the optical element (4) facing away from the LED chip (3) on which the reflective elements (6, 61, 62) are provided.

15. LED module (1) according to claim 12, wherein the color conversion plate or color conversion layer (7) has a constant thickness or a targeted profiling, wherein the thickness is preferably greater in a region aligned with the surface (30) of the LED chip (3) in the main emission direction (H), than in regionsthat are not aligned with the surface (30) of the LED chip (3) in the main emission direction (H).

16. LED module (1) according to claim 14 or 15, wherein the color conversion plate or color conversion layer (7) has a substantially continuous greenish/yellowish plate or layer (7), particularly preferably punctiform, particularly preferably directly above the LED chip (3), and preferably arranged in a separate region of a reddishemitting phosphor in the main emission direction (H).

17. LED module (1) according to one of the claims 14 or 15, wherein the color conversion plate or color conversion layer (7) further comprises diffuser particles.

18. LED module (1) according to one of the preceding claims, wherein the optical element (4) is fixed to the side (20) of the carrier (2) comprising the LED chip (3) by gluing, screws or other defined external bonding.

19. LED module (1) according to one of the preceding claims, wherein the surface (20) of the carrier (2) on which the LED chips (3) are applied, is reflective, preferably highly reflective, wherein the reflection property is produced through the material of the carrier (2), for example. aluminum, or corresponding processing, or coating of the carrier (2), for example with ceramic ink, white solder resist or silver.

20. LED module (1) according to one of the preceding claims, wherein the carrier (2) is a printed circuit board made of epoxy resin, a ceramic circuit board or an aluminum core printed circuit board (IMS).

21. LED module (1) according to one of the preceding claims, wherein the LED chip (3) is fixed through bare chip mounting or surface mounting on the carrier (2).

22. LED module (1) according to one of the preceding claims, wherein the LED module (1) has at least two or more LED chips (3), wherein one or more LED chips (3) is/are respectively associated with a translucent space (5) and surround(s) it, and wherein the LED chips (3) emit light having the same or different wavelength.

## Revendications

1. Module de LED (1), présentant :
- un support (2), en particulier une carte de circuit imprimé,
- au moins une puce LED (3) appliquée sur le support (2) ou introduite dans le support (2), et
- un élément optique (4), de préférence une plaque optique, qui limite, de préférence entoure, un espace (5) transparent qui est prévu au-dessus de la puce LED (3) et qui présente des particules diffusantes,
dans lequel la concentration des particules diffusantes dans une zone (43) qui, vu dans une direction de rayonnement principale (H) de préférence perpendiculaire à la surface (30) de la puce LED (3), est alignée avec celle-ci, est plus élevée que dans une zone (44) qui, vu dans la direction de rayonnement principale (H), n'est pas alignée avec la surface (30) de la puce LED (3) afin d'obtenir un rayonnement de lumière homogène, les parois de délimitation (50) formant l'espace (5) présentant une structurations destinée à améliorer le couplage de la lumière émise par la puce LED (3) dans l'élément optique (4) sous la forme d'une lentille de Fresnel.

2. Module de LED (1) selon la revendication 1, dans lequel, sur un côté (40) de l'élément optique (4) éloigné de la puce LED (3) et au moins dans une zone superficielle (41) alignée avec la surface (30) de la puce LED (3), vu dans une direction de rayonnement principale (H), il est prévu au moins un élément réfléchissant (6) de telle sorte que le rayonnement de la puce LED (3) dans la direction de rayonnement principale (H) est de préférence réparti de façon régulière sur la totalité de l'élément optique (4).

3. Module de LED (1), présentant .
- un support (2), en particulier une carte de circuit imprimé,
- au moins une puce LED (3) appliquée sur le support (2) ou introduite dans le support (2), et
- un élément optique (4), de préférence une plaque optique, qui limite, de préférence entoure, un espace (5) transparent prévu au-dessus de la puce LED (3),
dans lequel, sur un côté de l'élément optique (4) éloigné de la puce LED (3) et au moins dans une zone superficielle (41) alignée avec la surface (30) de la puce LED (3), vu dans une direction de rayonnement principale (H) perpendiculaire à celle-ci, il est prévu au moins un élément réfléchissant (6) de telle sorte que le rayonnement de la puce LED (3) dans la direction de rayonnement principale (H) est de préférence réparti de façon régulière sur la totalité de l'élément optique (4) pour obtenir un rayonnement de lumière homogène, les parois de délimitation (50) formant l'espace (5) présentant une structurations destinée à améliorer le couplage de la lumière émise par la puce LED (3) dans l'élément optique (4) sous la forme d'une lentille de Fresnel.

4. Module de LED (1) selon la revendication 3, dans lequel l'élément optique (4) présente des particules diffusantes, et les particules diffusantes soit sont disposées de façon ordonnée et en étant réparties de façon homogène dans l'élément optique (4), soit la concentration des particules diffusantes dans une zone (43) de l'élément optique (4) qui est alignée avec la surface (30) de la puce LED (3), vu dans la direction de rayonnement principale (H), est plus élevée que dans une zone (44) qui, vu dans la direction de rayonnement principale (H), n'est pas alignée avec la surface (30) de la puce LED.

5. Module de LED (1) selon l'une des revendications 2 à 4, dans lequel, sur un côté (40) de l'élément optique (4) éloigné de la puce LED (3), dans ou respectivement sur des zones superficielles (44) qui, vu dans la direction de rayonnement principale (H), ne sont pas alignées avec la surface (30) de la puce LED (3), il n'est prévu aucun élément réfléchissant ou des éléments réfléchissants (61, 62) avec respectivement ou au total une proportion réduite de surfaces réfléchissantes (63, 64) par rapport à l'élément réfléchissant (6) dans la zone superficielle (41) alignée avec la surface (30) de la puce LED (3), vu dans la direction de rayonnement principale (H), les autres surfaces réfléchissantes (61, 62) présentant une surface réfléchissante (63, 64) qui diminue de préférence en cas d'augmentation d'une distance à un axe (A) qui s'étend dans la direction de rayonnement principale (H).

6. Module de LED (1) selon l'une des revendications 2 à 5, dans lequel les éléments réfléchissants (6, 61, 62) sont fabriqués en matériaux très réfléchissants, comme par exemple un matériau métallique, par exemple de l'aluminium, de l'argent ou du chrome, en un autre matériau réfléchissant comme par exemple de l'encre céramique, de la silicone blanche ou du titanate de baryum, ou en feuilles microstructurées, les éléments réfléchissants (6, 61, 62) étant appliqués de préférence par revêtement de la surface (40) de l'élément optique (4) éloignée de la puce LED (3) ou par collage d'éléments réfléchissants (6) séparés.

7. Module de LED (1) selon l'une des revendications 2 à 6, dans lequel le côté (40) de l'élément optique (4) éloigné de la puce LED (3) est constitué de façon plane ou structurée, la structuration étant de préférence constituée de telle sorte que la surface (40) de l'élément optique (4) présente des zones inclinées, convexes ou concaves, les éléments réfléchissants (6, 61, 62) étant de préférence prévus sur les zones superficielles structurées, par exemple par revêtement ou par collage, de telle sorte que les éléments réfléchissants (6, 61, 62) présentent des surfaces réfléchissantes inclinées, convexes ou concaves.

8. Module de LED (1) selon l'une des revendications précédentes, dans lequel les parois de limitation (50, 52), de préférence de l'élément optique (4), formant l'espace (5) s'étendent à partir du support (2) en s'éloignant du support (2), en forme de pyramide, de cône ou de coupole, et convergent quand la distance au support (2) augmente.

9. Module de LED (1) selon l'une des revendications précédentes, dans lequel l'élément optique (4) présente au moins un creux (51), le creux (51) formant au moins une zone supérieure de l'espace (5), et les parois latérales (52) limitant le creux (51) formant au moins une zone supérieure des parois latérales (50) formant l'espace (5).

10. Module de LED (1) selon l'une des revendications précédentes, dans lequel la puce LED (3) est introduite dans un creux (21) dans le support (2), le creux (21) formant au moins une zone inférieure de l'espace (5), et les parois latérales (25) du creux (21) qui limitent le creux (21) formant au moins une zone inférieure des parois de délimitation (50) formant l'espace (5).

11. Module de LED (1) selon l'une des revendications précédentes, dans lequel l'espace (5) présente une cavité qui réalise une séparation entre la puce LED (3) et l'élément optique (4), ou dans lequel l'espace (5) est rempli d'une matière transparente, de préférence de la silicone.

12. Module de LED (1) selon l'une des revendications précédentes, dans lequel l'élément optique (4) est fabriqué en matériau très transparent, comme par exemple un matériau matriciel, par exemple de la résine époxyde, une matière plastique ou du verre.

13. Module de LED (1) selon l'une des revendications précédentes, dans lequel l'élément optique (4) présente des particules de conversion chromatique qui se présentent de préférence de façon répartie de manière homogène ou délibérément inhomogène dans l'élément optique (4).

14. Module de LED (1) selon l'une des revendications précédentes, dans lequel il est prévu, au-dessus de l'élément optique (4), vu dans la direction de rayonnement principale (H) de la puce LED (3), une autre couche ou plaque (7) qui présente des particules de conversion chromatique, dans lequel soit la plaque de conversion chromatique ou couche de conversion chromatique (7) est prévue sur la surface (40) de l'élément optique (4) éloignée de la puce LED (3), et de façon particulièrement préférée présente sur la surface (70) éloignée de l'élément optique (4) les éléments réfléchissants (6, 61, 62), soit dans lequel la plaque de conversion chromatique ou couche de conversion chromatique (7) est prévue sur les éléments réfléchissants (6, 61, 62) prévus sur la surface (40) de l'élément optique (4) éloignée de la puce LED (3).

15. Module de LED (1) selon la revendication 12, dans lequel la plaque de conversion chromatique ou couche de conversion chromatique (7) présente une épaisseur constante ou un profilage délibéré, l'épaisseur étant de préférence, dans une zone alignée avec la surface (30) de la puce LED (3), vu dans la direction de rayonnement principale (H), plus grande que dans les zones qui ne sont pas alignées avec la surface (30) de la puce LED (3) vu dans la direction de rayonnement principale (H).

16. Module de LED (1) selon la revendication 14 ou 15, dans lequel la plaque de conversion chromatique ou couche de conversion chromatique (7) présente une plaque ou respectivement couche (7) qui est essentiellement verdâtre/jaunâtre de façon continue, des zones séparées d'une matière luminescente émettant dans le rougeâtre étant disposées de préférence de façon ponctuelle, de façon particulièrement préférée directement au-dessus de la puce LED (3), de préférence vu dans la direction de rayonnement principale (H).

17. Module de LED (1) selon l'une des revendications 14 ou 15, dans lequel la plaque de conversion chromatique ou couche de conversion chromatique (7) présente en outre des particules diffusantes.

18. Module de LED (1) selon l'une des revendications précédentes, dans lequel l'élément optique (4) est fixé par collage, vissage ou liaison adhésive extérieure de façon définie sur le côté (20) du support (2) présentant la puce LED (3).

19. Module de LED (1) selon l'une des revendications précédentes, dans lequel la surface (20) du support (2) sur lequel sont appliquées les puces LED (3) est réfléchissante, de préférence très réfléchissante, la caractéristique de réflexion étant produite par la matière du support (2), par exemple de l'aluminium, un traitement correspondant ou un revêtement du support (2), par exemple avec de l'encre céramique, du vernis épargne blanc ou de l'argent.

20. Module de LED (1) selon l'une des revendications précédentes, dans lequel le support (2) est une carte de circuit imprimé en résine époxyde, une carte de circuit imprimé céramique ou une carte de circuit imprimé à noyau en aluminium (IMS).

21. Module de LED (1) selon l'une des revendications précédentes, dans lequel la puce LED (3) est fixée au moyen d'un montage de puce nue ou d'un montage en surface sur le support (2).

22. Module de LED (1) selon l'une des revendications précédentes, dans lequel le module de LED (1) présente au moins deux puces LED (3) ou plus, un espace (5) transparent étant respectivement affecté à une ou plusieurs puces LED (3) et entourant celle-ci ou celles-ci, et les puces LED (3) émettant de la lumière de longueur d'onde identique ou différente.
